# EUROPEAN PATENT APPLICATION

(11) **EP 1 729 201 A1**
(43) Date of publication of application: **06.12.2006**
(21) Application number: 05291202.9
(22) Date of filing: 03.06.2005
(51) Int. Cl.: G06F 1/18, H05K 9/00, G11B 33/14

(54) **Shielding means**

(71) Applicant: Thomson Licensing, 92100 Boulogne-Billancourt (FR)
(72) Inventor: Pang, Zhen, Peng c/o Thonson Industry Co., Ltd., 518038 Shenzen (CN); LV, Yan, Hui c/o Thonson Industry Co., Ltd., 518038 Shenzen (CN); Zhang, Chi c/o Thonson Industry Co., Ltd., 518038 Shenzen (CN); Pu, Yong, Dong c/o Thonson Industry Co., Ltd., 518038 Shenzen (CN)
(74) Representative: Rossmanith, Manfred

(57) **Abstract**

A shielding means for function against EMC is provided to be installed in an electronic product, such as a DVD player which comprises a chassis, a back panel, a PSD board fixed on a bottom of the chassis, and at least one main IC chip installed on the PSD board. The shielding means is located in the chassis in a position that is across above the main IC chip. Advantageously, high radicalization from the electronic component under the shielding means can be reduced obviously, and the manufacturing cost of the products is greatly reduced.

## Description

### FIELD OF THE INVENTION

The present invention relates to a shielding means, and more particularly to a shielding means installed inside an electronic product for function against EMC.

### BACKGROUND OF THE INVENTION

Electromagnetic compatibility (EMC) is the ability of a device or system to function without error in its intended electromagnetic environment. EMC is a term used to describe the interaction of electrical and electronic equipment with its electromagnetic (EM) environment and with other equipment. EMC deals with emissions and immunity of electronic devices. All electrical devices generate emission and are susceptible to EM phenomena such as lighting-induced transients, electrostatic discharges, electrical fast transients, radiofrequency fields generated by transmitters and hand-held communication devices. Moreover, an electronic device can be also susceptible to self-generated interferences. A good EMC design will minimize both susceptibility to, and generation of EM disturbances.

Meeting today's EMC compliance requirements is an extensive and complex task. There are numerous standards and requirements depending upon product, application and territory. When designing electronic equipments, such as DVD players or other audio/video equipment, there is always a challenge to reduce the cost and provide sufficient function against EMC.

Conventional DVD players normally comprise a chassis, a DSP board fixed on a bottom surface in the chassis, and a metal cover provided on the top of chassis. The metal top cover performs as a shield for all electronic components installed on the DSP board. In order to reduce the cost of the products, there is a trend to use plastic top cover instead of the metal cover.

It is known in this art, various kinds of shielding means have been designed for these electronic components in order to function against EMC. For example, a type of shield fully cover on the PSD board is used in many products. However, these types of shielding means of prior arts for electronic products available on the market now either limit the stylish design of the appearance of products or increase the manufacturing cost of the products.

Therefore, an improved shielding means for the electronic product is desirable to solve the problems exiting in the prior arts.

### SUMMARY OF THE INVENTION

A shielding means for function against EMC is provided to be installed inside an electronic product, such as a DVD player which comprises a chassis, a back panel, a PSD board fixed on a bottom of the chassis, and at least one main electronic component installed on the PSD board. The shielding means is located in the chassis in a position that is across above the main electronic component.

Advantageously, radicalization from the electronic component under the shielding means can be reduced obviously, and the manufacturing cost of the products is greatly lowered.

### BRIEF DESCRIPTION OF DRAWINGS

Fig. 1 is a perspective view showing a shielding means installed in a chassis of an electronic product according to the present invention; and
Fig. 2 is a perspective view of the shielding means according to the present invention.

### DETAIL DESCRIPTION OF PREFERRED EMBODIMENTS

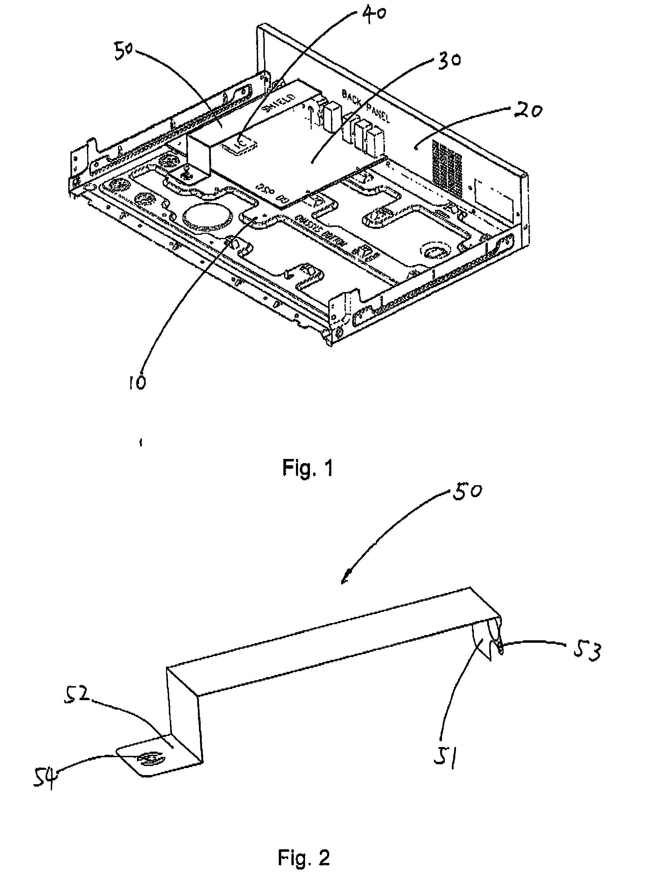

With reference to Fig. 1, as a simplified example, an electronic product mainly comprises a chassis 10, a back panel 20, a DSP board 30 and a plastic top cover which is omitted in the drawing in order to expose the internal structure of the product. Wherein various electronic components including at least one main electronic component 40, for example a CPU chip 40 are respectively installed on the board 30. According to the present invention, a shielding means 50 is fixed on the board 30 and located in the chassis 10 in a position that is across above the main electronic component 40.

As shown in Fig. 2, the shielding means 50 is an integrally formed U-shaped metal plate having two bended portion respectively formed at opposite ends of a horizontal middle portion. A first end of the shielding means 50 is formed with a bended portion 51 which is fixedly attached to the back panel 20. A second end of the shielding means 50 is formed with a L-shaped bended portion 52 which is fixedly mounted on the bottom of the chassis 10. The bended portion 51 of the shielding means 50 is defined with a fixing hole 53, therefore the bended portion 51 can be fixed with the back panel 20 by means of a screw (not shown in the drawings) extending through the fixing hole 53. The L-shaped bended portion 52 is defined with a fixing hole 54 on a horizontal part corresponding to a fixing hole defined on the bottom of the chassis 10, therefore the second end of the shielding means 50 can be fixed on the bottom of the chassis 10 by means of a screw, as shown in Fig. 1.

The shielding means 50 advantageously reduce the radicalization emitted from the electronic components 40 installed on the board beneath the horizontal middle portion of the shielding means 50. Although the above example illustrates a preferred embodiment of the present invention, the shielding means 50 may be formed in other shapes with other practicable connecting means, which can be implemented by the skilled person in the art obviously. Therefore, the above detail description is used to explain the principle of the present invention only but not to limit the scope of the invention.

## Claims

1. A shielding means (50) for function against EMC being installed in an electronic product, which comprises a chassis (10), a PSD board (30) fixed on a bottom of the chassis (10), and at least one main electronic component (40) installed on the PSD board (30), **characterized in that**
the shielding means (50) is located in the chassis (10) in a position that is across above the main electronic component(40).

2. The shielding means (50) as claimed in claim 1, **characterized in that** the shielding means (50) is arranged to cooperate with a back panel (20) of the electronic product.

3. The shielding means (50) as claimed in claim 1, **characterized in that** the shielding means (50) is an integrally formed metal plate having two bended portions respectively formed at opposite ends of a horizontal middle portion, a first end of the shielding means (50) is formed with a bended portion (51) which is fixedly attached to the back panel (20), a second end of the shielding means (50) is formed with a L-shaped bended portion (52) which is fixedly mounted on the bottom the chassis (10).
